# NEUE EUROPÄISCHE PATENTSCHRIFT

(11) **EP 3 400 423 B2**
(45) Veröffentlichungstag und Bekanntmachung des Hinweises auf die Entscheidung über den Einspruch: **25.03.2026**
(45) Hinweis auf die Patenterteilung: 07.10.2020
(21) Anmeldenummer: 18717253.1
(22) Anmeldetag: 27.03.2018
(51) Int. Cl.: G01D 5/14, H02K 11/215

(54) **ABSCHIRMSYSTEM FÜR MAGNETISCHES DREHGEBER-SENSORSYSTEM**
SHIELDINGSYSTEM FOR MAGNETIC ROTATION SENSOR SYSTEM
SYSTÈME DE BLINDAGE POUR SYSTÈME DE DÉTECTION DE ROTATION MAGNÉTIQUE

(30) Priorität: 27.03.2017 DE 102017106479
(43) Veröffentlichungstag der Anmeldung: 14.11.2018
(73) Patentinhaber: Fritz Kübler GmbH, 78054 Villingen-Schwenningen (DE)
(72) Erfinder: GANSER, Christian, 78087 Mönchweiler (DE); HINTZ, Fred, 78112 St. Georgen (DE); BECKER, Philipp, 78050 Villingen-Schwenningen (DE); STEINER, Viktor, 78532 Tuttlingen (DE)
(74) Vertreter: Witte, Weller & Partner Patentanwälte mbB
(86) Internationale Anmeldenummer: PCT/EP2018/057801
(87) Internationale Veröffentlichungsnummer: WO 2018/178089

(56) Entgegenhaltungen:
- WO-A1-2009/015496
- WO-A1-2017/034691
- DE-A1- 102010 040 857
- DE-A1- 102012 220 139
- DE-T5- 112013 001 757
- JP-A- 2001 004 405
- US-A- 5 450 009

## Beschreibung

Die vorliegende Erfindung betrifft ein (magnetisch wirkendes) Abschirmsystem für ein magnetisches Drehgeber-Sensorsystem in einer Umgebung einer Maschine, wie zum Beispiel in der Umgebung eines E-Motors mit Magnetbremse, mit einem (starken) magnetischen, störsignalerzeugenden Stör- bzw. Streufeld, wobei das Drehgeber-Sensorsystem einen Magnetsensor, ein Polrad und vorzugsweise einen Polradträger aufweist.

Elektrische Maschinen, wie zum Beispiel Elektromotoren, verursachen im Betrieb elektromagnetische Störfelder, die je nach Leistungsklasse der elektrischen Maschine und insbesondere der Magnetbremse erheblichen Einfluss auf die Funktion von elektronischem Zubehör haben können. Ein exemplarisches elektronisches Zubehör ist in einem magnetisch betriebenen Drehgeber-Sensorsystem zu sehen. Magnetische Drehgeber-Sensorsysteme weisen üblicherweise einen Magnetsensor, ein ringförmiges Polrad und vorzugsweise einen hülsenförmigen Polradträger auf, wie es nachfolgend noch näher erläutert werden wird. Das Polrad ist entweder direkt oder über einen Polradträger drehfest auf der Maschinenwelle montiert. Der Magnetsensor ist in einem Abstand von wenigen Millimetern dazu angeordnet. Der Magnetsensor (d.h. der Sensorkopf) kann zum Beispiel durch einen Hall-Sensor, einen AMR-Sensor, einen GMR-Sensor oder einen TMR-Sensor realisiert sein. Allgemein basieren xMR-Sensoren auf verschiedenen Effekten. Den xMR-Sensoren ist aber das Folgende gemeinsam: sie verändern ihren Widerstand in Abhängigkeit eines externen Magnetfelds; sie werden typischerweise durch einfache passive Widerstands-(Halb-)Brücken realisiert, die - nahezu sofort - nach dem Einschalten einer Versorgungsspannung, d.h. trägheitsfrei, ein auswertbares Signal liefern; und sie lassen sich durch eine entsprechende Strukturierung hochohmig ausgestalten.

Bis heute werden derartige Magnetsensoren von Drehgeber-Sensorsystemen nicht in der unmittelbaren Umgebung von elektrischen Maschinen eingesetzt, weil ein magnetisches Nutzfeld des Polrads vom Störfeld überlagert wird, was eine signaltechnisch sinnvolle Auswertung des magnetischen Nutzfelds unmöglich macht. Das Nutzfeld, welches vom Polrad, das als Maßverkörperung dient, geliefert wird, ist zwar durch den Magnetsensor abtastbar, aber nicht auswertbar, weil es vom Störfeld überlagert wird.

Weiteres Zubehör für die elektrische Maschinen, wie zum Beispiel Federkraftbremsen, verhindern zusätzlich oder allein den Einsatz eines magnetischen Drehgeber-Sensorsystems. Federkraftbremsen werden über eine integrierte Spule elektromagnetisch betätigt und haben ihren Einsatzbereich dort, wo Massen abgebremst oder festgehalten werden müssen. Die Bremskraft wird durch Druckfedern erzeugt, so dass ein durch Reibung erzeugtes Bremsmoment auch dann verfügbar ist, wenn eine Energieversorgung ausfällt. Im normalen Betrieb verursacht die Bremse aber starke magnetische Störfelder, die das magnetische Nutzfeld eines Drehgeber-Sensorsystems auf eine unbrauchbare Weise verzerren.

Da Drehgeber-Sensorsysteme allgemein aufgrund eines sehr engen und begrenzten Bauraums nur in unmittelbarer Nähe der Federkraftbremse angeordnet werden können, lässt sich das Störfeld über eine ausreichende Entfernung zwischen der Bremse und dem Drehgeber-Sensorsystem nicht abschwächen. Deshalb werden bei derartigen Anwendungen bis heute überhaupt keine Magnetsensoren verwendet. Bisher werden bei derartigen Anwendungen Sensoren verwendet, die auf anderen Wirtprinzipien beruhen. Meistens werden optische Sensoren eingesetzt. Diese sind in der Regel teurer und anfälliger gegenüber Verschmutzungen, wenn sie nicht bereits in einer eingekapselten Form bereitgestellt werden, was aber wiederum den Preis erhöht. Der Einbauraum, der von optischen Drehgeber-Systemen benötigt wird, ist erheblich größer als der von magnetischen Drehgeber-Sensorsystemen.

Das Dokument DE 10 2016 002 387 A1 offenbart eine magnetisch abgeschirmte Sensoranordnung. Das Dokument US 2014/0084757 A1 offenbart eine rotierende elektrische Maschine. Das Dokument US 2014/0070649 A1 offenbart einen Resolver mit einer Montagestruktur. Das Dokument JP 2014-87122 A offenbart eine sich drehende elektrische Maschine. Das Dokument DE 10 2012 220 139 A1 offenbart eine magnetische Messanordnung und eine korrespondierende Sensoranordnung zur Bewegungserfassung eines bewegten Bauteils . Das Dokument WO 2009/015496 A1 offenbart einen elektrischen Motor mit einer Rotorpositionssensoranordnung. Das Dokument WO 2017/034691 A1 offenbart eine Sensoranordnung.

Es ist daher eine Aufgabe der vorliegenden Erfindung, den Einsatz eines magnetischen Drehgeber-Sensorsystems in einer magnetisch gestörten Umgebung zu ermöglichen. Die Lösung soll kostengünstig in der Herstellung und einfach in der Anwendung (z.B. Montage) sein. Die Lösung soll für unterschiedliche Umgebungen (unterschiedliche elektrische Maschinen, unterschiedliches elektrisches Zubehör, unterschiedlich starke Störfelder, unterschiedliche Bauräume, etc.) anwendbar sein.

Diese Aufgabe wird durch ein Drehgeber-Sensorsystem gemäß dem beigefügten Anspruch 1 gelöst.

Die Lösung besteht also darin, mit, vorzugsweise magnetisch leitfähigen, Ablenkelementen (z.B. Biegeteile, Drehteilen, oder Ähnlichem), das durch die Bremsenspule und/oder durch den E-Motor verursachte magnetische Störfeld, um einen räumlichen Bereich - d.h. das Messvolumen - herumzuführen, in welchem der Magnetsensor das Nutzfeld der Maßverkörperung (Polrad) messen soll und muss. Eine Geometrie und ein Material des Ablenkelements sind von den jeweils vorhandenen örtlichen Gegebenheiten abhängig und können sich somit von Umgebung zu Umgebung bzw. von Anwendung zu Anwendung unterscheiden. Dies bedeutet, dass die Geometrien und Materialen an die jeweilige Gegebenheit anzupassen sind.

Da magnetische Felder nicht gedämpft oder absorbiert werden können, wird das Störfeld umgeleitet, so dass das Störfeld das zu messende Nutzfeld nicht beeinflusst. Dies bedeutet, dass zumindest solche Komponenten des Störfelds umgelenkt werden, die zu einer Verfälschung der zu messenden Nutzfeldkomponenten führen. Dabei ist es nicht erforderlich, dass das Störfeld zu 100 % aus dem Messvolumen "verdrängt" wird. Vernachlässigbar kleine Störfeldkomponenten, die sich parallel zur Messrichtung des Drehgeber-Sensorsystems erstrecken, sind geduldet. Störfeldkomponenten, die zum Beispiel senkrecht zur Vorzugsmessrichtung des Drehgeber-Sensorsystem orientiert sind, sind unbeachtlich, da sie das Nutzfeld (in einer Vorzugsmessrichtung) nicht beeinflussen. Ein "störfeldfreies" Messvolumen kann also durchaus auch noch betragsmäßig größere Störfeldkomponenten aufweisen, solange diese Komponenten ausreichend abweichend (vorzugsweise senkrecht) von der Vorzugsmessrichtung des Drehgeber-Sensorsystems orientiert sind. Generell wird aber eine hinreichende Änderung einer Störfeldverteilung im Bereich der umfänglichen Oberfläche des Polrads erzielt, wo der Magnetsensor angeordnet ist.

Das mindestens eine Ablenkelement ist so angeordnet, dass das mindestens eine Ablenkelement das Messvolumen derart (räumlich) umgibt, dass Komponenten des Störfelds, die annähernd parallel zu einer (Vorzugsmess-)Messrichtung des Magnetsensors orientiert sind, durch das mindestens eine Ablenkelement um das Messvolumen herumgeführt werden und dass ein Durchgang für das rotierende Polrad und den Polradträger verbleibt, sofern ein Polradträger verwendet wird.

Das mindestens eine Ablenkelement ist also ähnlich einem Faraday'schen Käfig ausgebildet, dessen Innenraum frei von elektrischen Feldern ist, nur mit der Ausnahme, dass es sich im vorliegenden Fall um magnetische Felder handelt und dass im Inneren des Messvolumens das Nutzfeld durch das Polrad erzeugt wird.

Da sich das Polrad aufgrund seiner drehfesten Verbindung mit der Maschinenwelle dreht, ist es erforderlich, einen Durchgang durch das umgebende Ablenkelement bzw. die umgebenden Ablenkelemente bereitzustellen. Entsprechende Durchgangsöffnungen sind dabei vorzugsweise so angeordnet und gewählt, dass sie entlang von Störfeldkomponenten orientiert sind, die das Nutzfeld nicht beeinflussen (können).

Ferner ist ein zweites Ablenkelement vorgesehen. Das erste (und zweite) Ablenkelement ist vorzugsweise plattenförmig ausgebildet. Die ersten und zweiten Ablenkelemente erstrecken sich längs jeweils parallel zur Maschinenwelle, wobei das erste Ablenkelement radial zwischen der Maschinenwelle und dem Polrad angeordnet ist und wobei das zweite Ablenkelement radial außerhalb des Polrads und des Magnetsensors angeordnet sein kann.

Bei dieser Ausführungsform wird insbesondere davon ausgegangen, dass das Störfeld (in der Sensorebene) im Wesentlichen senkrecht aus der Maschinenwelle austritt. Das Polrad sitzt konzentrisch auf der Maschinenwelle. Der Magnetsensor sitzt radial außerhalb des Polrads mit minimalem Abstand zum Polrad (z.B. 0,5 bis 5 mm, abhängig von der Einzel-Pollänge des Polrades). Durch die radiale Positionierung des ersten Ablenkelements zwischen der Maschinenwelle und dem Polrad werden die Hauptkomponenten des Störfelds - auf der Eintrittsseite - um das Messvolumen herumgelenkt. Das Störfeld trifft in dieser Konfiguration nahezu senkrecht auf das erste Ablenkelement. Das erste Ablenkelement stellt eine Art Schutzwall für den nutzfeldrelevanten Teil des Polrads und für den Magnetsensor dar. Das zweite Ablenkelement kann optional austrittsseitig angeordnet und vorzugsweise parallel zum ersten Ablenkelement orientiert sein. Die vom ersten Ablenkelement umgelenkten Störfeldkomponenten treten hier aus dem zweiten Ablenkelement aus, um sich wieder in den "normalen" Verlauf des Störfelds einzugliedern.

Ferner ist ein drittes Ablenkelement vorgesehen sein, welches sich im Wesentlichen entlang der Rotationsebene erstreckt und welches vorzugsweise das erste und das zweite Ablenkelement verbindet.

Das dritte Ablenkelement verhindert, dass Störfeldkomponenten, die aus der Maschinenwelle axial beabstandet zur Rotations- und Messebene austreten, "seitlich" in das Messvolumen einstreuen bzw. eintreten, wo keine Ablenkelemente vorgesehen sind.

Wenn das dritte Ablenkelement die ersten und zweiten Ablenkelemente physisch miteinander verbindet, werden die umzulenkenden Magnetfeldlinien des Störfelds sicher um das Messvolumen herum geleitet. Da die Ablenkelemente nicht unterbrochen sind, kann das Störfeld auch nicht auf ungewünschte Weise aus den Ablenkelementen austreten und gegebenenfalls somit dennoch unerwünschte Feldkomponenten in das Messvolumen entsenden.

Weiter ist es von Vorteil, wenn das Abschirmsystem ferner das Polrad und den Polradträger aufweist, der insbesondere einen axialen Hülsenabschnitt mit einem radial vorstehenden Kragenabschnitt aufweist, in welchem die Permanentmagneten radial befestigt sind, wobei der Kragenabschnitt zumindest in einem Maschinenwellen-Nahbereich aus einem magnetisch nicht leitenden Material gefertigt ist und wobei das erste Ablenkelement zwischen dem Polrad, der Maschinenwelle und dem Kragenabschnitt positioniert ist.

Der Polradträger ist also so ausgebildet, dass das erste Ablenkelement das Polrad hintergreifen kann. Das Polrad, die Maschinenwelle und der Kragenabschnitt definieren einen U-förmigen Querschnitt (Schnitt entlang der Achse der Maschinenwelle), in welchen das erste Ablenkelement hineinreicht. Das erste Ablenkelement definiert gemeinsam mit dem zweiten und dritten Ablenkelement selbst einen U-förmigen Querschnitt (in einer Ebene parallel zur Achse der Maschinenwelle). Die beiden U-förmigen Querschnitte greifen ineinander und sorgen so für eine effektive Umleitung.

Wenn im Kontext der vorliegenden Erfindung von "magnetisch leitend" und "magnetisch nicht leitend" gesprochen wird, so ist damit generell gemeint, dass ein entsprechendes Bauteil aus einem Material gefertigt ist, das eine besondere magnetische Permeabilität bzw. magnetische Leitfähigkeit "µr" aufweist. Die magnetische Permeabilität bestimmt die Durchlässigkeit von Materie für magnetische Felder. Magnetische Materialien lassen sich anhand ihrer Permeabilitätszahl klassifizieren. Man unterscheidet zwischen diamagnetischen Materialien, paramagnetischen Materialien und ferromagnetischen Materialien. Diamagnetische Materialien bzw. Stoffe besitzen eine geringfügig kleinere Permeabilität als Vakuum (0 ≤ µᵣ<1). Diamagnetische Stoffe haben das Bestreben, das Magnetfeld aus ihrem Inneren zu verdrängen. Die Stoffe magnetisieren sich gegen die Richtung eines externen Magnetfelds, so dass µᵣ<1 gilt. Paramagnetische Stoffe weisen eine Permeabilitätszahl auf, die etwas größer als 1 ist (µᵣ>1). In paramagnetischen Stoffen richten sich die atomaren magnetischen Momente in externen Magnetfeldern aus und verstärken damit das Magnetfeld im Inneren des Stoffs. Die Magnetisierung ist also positiv und damit gilt µᵣ>1. Ferromagnetische Stoffe weisen eine sehr große Permeabilitätszahl µᵣ von bis zu 300.000 auf. Ferromagnetische Stoffe richten ihre magnetischen Momente parallel zum äußeren Magnetfeld aus und tun dies in einer stark verstärkenden Weise. Magnetisch leitende Stoffe bzw. Materialien im Sinne der Erfindung weisen eine Permeabilität µr » 1 auf. Magnetisch nicht leitende Stoffe bzw. Materialien leiten im Sinne der vorliegenden Erfindung eine Permeabilität µr von ungefähr 1 auf.

Ferner kann ein viertes Ablenkelement vorgesehen werden, welches sich parallel, axial beabstandet und radial gegenüberliegend zum dritten Ablenkelement erstreckt, wobei die dritten und vierten Ablenkelemente vorzugsweise mindestens so groß wie eine Grundfläche des Magnetsensors (Sensorkopf und weitere Elemente wie z.B. Auswerteelektronik und Schnittstellen, etc.) dimensioniert sind und wobei das vierte Ablenkelement vorzugsweise mit dem zweiten Ablenkelement verbunden ist.

Die dritten und vierten Ablenkelemente umgeben den Magnetsensor in axialer Richtung Sandwich-artig und verhindern so, dass Störfeldlinien den sinnvollen Betrieb des Magnetsensors unterbinden. Die dritten und vierten Ablenkelemente lenken die Störfeldlinien um den Magnetsensor herum.

Die optionale physische Verbindung des vierten Ablenkelements mit dem zweiten Ablenkelement verbessert wiederum die Umleitung des Störfelds um das sensitive Messvolumen herum.

Vorzugsweise bildet das mindestens eine Ablenkelement ein Gehäuse des Magnetsensors aus, das den Magnetsensor aufnimmt und das ferner den oder die nutzfelderzeugenden Permanentmagneten, zumindest teilweise, umgibt.

Drehgeber-Sensorsysteme messen üblicherweise die Position und/oder die Geschwindigkeit einer rotierenden Maschinen- bzw. Geberwelle. Das Drehgeber-Messsystem wird üblicherweise radial beabstandet in einer Messebene senkrecht zur Wellenachse positioniert. Diese Randbedingungen sind also üblicherweise immer gleich. Wesentliche Faktoren, die sich ändern können, stellen ein Durchmesser der Maschinenwelle sowie eine Stärke und Ausrichtung des Störfelds am Ort des Drehgeber-Sensorsystems dar. Der veränderliche Durchmesser hat Auswirkungen auf den Durchmesser des Polrads. Der Durchmesser des Polrads wird auch durch eine Auflösung (Anzahl und Größe der Magnetpole) beeinflusst. Abhängig vom einzusetzenden Polrad kann somit ein Baukastensystem bereitgestellt werden, bei dem das Gehäuse des Magnetsensors an das jeweils gewählte Polrad angepasst ist. Das mindestens eine Ablenkelement muss also nicht separat zum Magnetsensor vorgesehen werden, sondern ist bereits in dem Magnetsensor - genauer gesagt in dessen Gehäuse - integriert.

Bei elektrischen Maschinen ist der Bauraum oft sehr begrenzt, so dass es nicht möglich ist, das Störfeld durch eine entsprechende Beabstandung des Drehgeber-Sensorsystems zu kompensieren. Die kompakte Bauweise der elektrischen Maschinen, insbesondere von E-Motoren, verbietet insbesondere die Verwendung von großdimensionierten Drehgeber-Sensorsystemen, wie zum Beispiel optischen Drehgebern. Dies wiederum bedeutet, dass das Drehgeber-Sensorsystem sehr nahe an der Störfeldquelle positioniert werden muss. Insbesondere in der Umgebung von elektrischen Maschinen, die mit elektromagnetischem Zusatzzubehör betrieben werden, ist bisher kein Einsatz von magnetisch betriebenen Drehgeber-Sensorsystemen bekannt. Mit dem vorliegenden Abschirmsystem ist dies aber nun möglich.

Ferner hat es sich als vorteilhaft erwiesen, wenn sich das mindestens eine Ablenkelement in der Umfangsrichtung mindestens entlang dem Permanentmagneten erstreckt, die zum Erzeugen des durch den Magnetsensor auswertbaren Nutzfelds erforderlich sind.

Das mindestens eine Ablenkelement ist also so dimensioniert, dass auch Komponenten des Störfelds blockiert werden, die seitlich in das Messvolumen eindringen können.

Weiter ist es bevorzugt, wenn das Abschirmsystem radial kürzer und axial sehr viel kürzer als die Maschine selbst baut.

Dies ermöglicht die Integration eines magnetischen Drehgeber-Sensorsystems in bestehende elektrische Maschinen, insbesondere in E-Motoren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1A: eine Seitenansicht einer Maschinenumgebung mit einem Drehgeber-Sensorsystem ohne Störfeld;
- Fig. 1B: eine Draufsicht auf die Umgebung der Fig. 1A;
- Fig. 1C: eine Seitenansicht einer Maschinenumgebung mit einem Drehgeber-Sensorsystem und mit einem Störfeld;
- Fig. 1D: eine Draufsicht auf die Umgebung der Fig. 1C;
- Fig. 2A: einen Graphen, der eine berechnete Umdrehungsrate für die Umgebung der Figuren 1A und 1B angibt;
- Fig. 2B: einen Graphen, der eine berechnete Umdrehungsrate für die Umgebung der Figuren 1C und 1D angibt;
- Fig. 3: eine perspektivische Schnittansicht einer Umgebung ähnlich den Figuren 1B und 1D ohne ein Abschirmsystem;
- Fig. 4: eine Schnittansicht einer Maschinenumgebung inklusive einem Abschirmsystem;
- Fig. 5: eine perspektivische Ansicht des Abschirmsystems der Fig. 4;
- Fig. 6: ein Schnitt entlang einer Linie VI-VI der Fig. 5;
- Fig. 7: eine Schnittansicht entlang der Linie VII-VII der Fig. 5;
- Fig. 8: eine Schnittansicht entlang der Linie VIII-VIII der Fig. 5;
- Fig. 10: eine perspektivische Ansicht einer weiteren alternativen Ausführungsform des Abschirmsystems; und
- Fig. 11: eine Schnittansicht der Fig. 10.

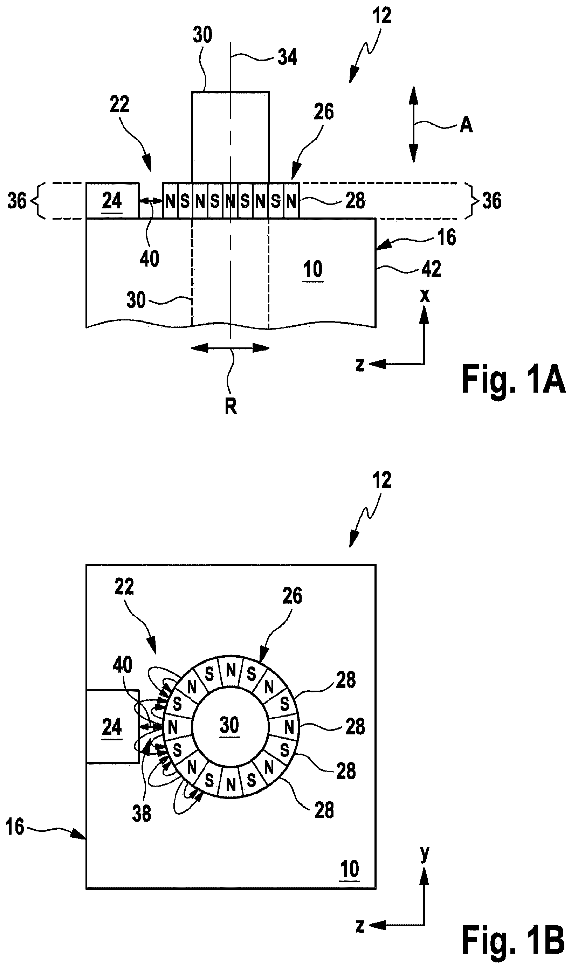

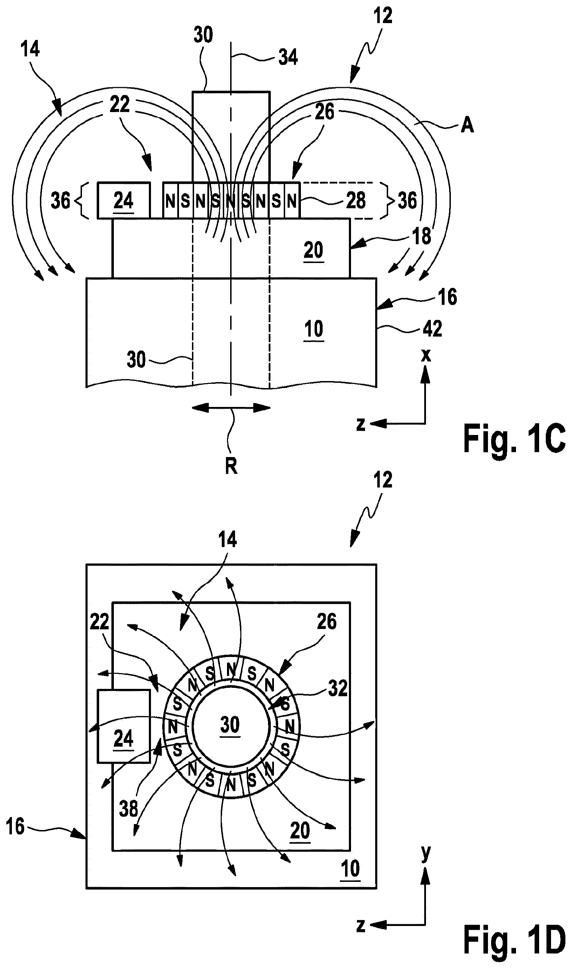

Die Figur 1 zeigt eine typische Anwendung am Beispiel eines herkömmlichen Elektromotors 10 (nachfolgend auch kurz nur als "Motor" 10 bezeichnet) in einer Umgebung 12 ohne magnetisches Störfeld (Figuren 1A und 1B) und mit einem wirkenden, aktiven Störfeld (Figuren 1C und 1D). Der Motor 10 stellt ein Beispiel für eine elektrische Maschine 16 dar, bei der die vorliegende Erfindung Anwendung findet. Die Figuren 1A und 1B zeigen eine Seitenansicht und eine Draufsicht auf den Motor 10, der ohne weiteres Zubehör 18 störfeldfrei betrieben wird. Die Figuren 1C und 1D zeigen eine Seitenansicht und eine Draufsicht auf einen Motor 10 inklusive einer (Federkraft-)Bremse 20, die ein exemplarisches Zubehör 18 darstellt. Die Bremse 20 stellt eine exemplarische Quelle für ein Störfeld 14 dar. Generell kann das Störfeld 14 durch das Zubehör 18 und/oder die Maschine 16 hervorgerufen werden.

Die nachfolgende Beschreibung folgt unter gleichzeitiger Bezugnahme auf jede der Figuren 1A bis 1D.

Die Figuren 1A und 1B zeigen einen störfeldfreien Betrieb eines magnetischen Drehgeber-Sensorsystems 22 (nachfolgend auch kurz als "Sensorsystem 22" bezeichnet). Das Sensorsystem 22 weist einen Magnetsensor 24 und ein Polrad 26 auf. Das Polrad 26 stellt eine Maßverkörperung des Sensorsystems 22 dar. Das Polrad 26 weist mindestens zwei Permanentmagneten 28 unterschiedlicher magnetischer Polarität auf. In der Fig. 1 ist eine Vielzahl von Permanentmagneten 28 unterschiedlicher magnetischer Polarität gezeigt, die in Umfangsrichtung auf gleichem Radius mit wechselnder Polarität (Nordpole und Südpole) angeordnet sind. Das Polrad 26 ist drehfest auf einer Maschinenwelle 30 (nachfolgend auch kurz als Welle 30 bezeichnet) angeordnet. Das Polrad 26 kann über einen optional vorgesehenen Polradträger 32 (vgl. Fig. 1D) drehfest an der Welle 30 montiert werden. Der Polradträger 32 kann unterschiedliche Geometrien aufweisen. In den Figuren 1C und 1D ist der Polradträger 32 z.B. ringförmig ausgebildet und eingerichtet, formschlüssig auf der Welle 30 (drehfest) zu sitzen. Der Polradträger 32 ist vorzugsweise aus einem magnetisch nicht leitenden Material hergestellt, wie es nachfolgend näher erläutert werden wird.

Die Welle 30 erstreckt sich axial entlang einer Wellenachse 34 (vgl. Figuren 1A und 1C). Eine entsprechende axiale Richtung A, die parallel zur Wellenachse 34 verläuft, ist in Fig. 1A angedeutet. Eine radiale Richtung R ist in Fig. 1A ebenfalls durch einen Pfeil angedeutet. Die radiale Richtung R steht senkrecht auf der Wellenachse 34 und der Maschinenwelle 30. Die Richtungen A und R sind allgemein für alle gezeigten Figuren gültig.

Die Permanentmagneten 28 des Polrads 26 erzeugen in einer (Sensor-)Ebene 36 (vgl. Figuren 1A und 1C) ein magnetisches Nutzfeld 38 (vgl. Fig. 1B). Die Ebene 36 kann entlang der axialen Richtung A unterschiedlicher Abmessungen aufweisen, je nach verwendetem Sensorkopf (Hall oder xMR). Die Abmessung in der axialen Richtung A hängt also unter anderem vom eingesetzten Typ des Magnetsensors 24 ab. Die Ebene 36 steht üblicherweise senkrecht auf der Maschinenwelle 30 und ist somit radial orientiert. Das vom Sensor 24 sichtbare und auswertbare Nutzfeld 38 wird nur durch solche der Permanentmagneten 28 erzeugt, die sich in unmittelbarer räumlicher Nähe des Magnetsensors 24 befinden, so dass der Magnetsensor 24 Änderungen der Richtung und/oder Amplitude des Nutzfelds 38 zur Bestimmung einer Drehzahl und/oder relativen oder absoluten Winkelposition der Maschinenwelle 30 auswerten kann. Deshalb sitzt der Magnetsensor 24 auch radial relativ nahe am Polrad 26. In den Figuren 1A bis 1D ist der Magnetsensor 24 jeweils radial außerhalb des Polrads 28 angeordnet. Es versteht sich, dass der Magnetsensor 24 alternativ auch radial innerhalb des Polrads 26 - bei entsprechender Ausgestaltung des Polrads 26 - sitzen kann. In den Figuren 1A und 1B ist eine (Vorzugs-)Messrichtung 40 durch einen Doppelpfeil angegeben. Die Vorzugsmessrichtung 40 ist aufgrund der Relativpositionierung des Magnetsensors 24 und des Polrads 26 radial ausgerichtet. Die Vorzugsmessrichtung 40 ist im Beispiel der Figuren 1A bis 1D parallel zur Z-Richtung eines Kartesischen Koordinatensystems XYZ ausgerichtet, das für alle Figuren 1A bis 1D gleich ist. Üblicherweise ist die Vorzugsmessrichtung 40 radial orientiert.

Die Figuren 1C und 1D zeigen den Motor 10 der Figuren 1A und 1B, der um ein Zubehör 18 in Form einer Bremse 20, insbesondere einer Federkraftbremse 20, ergänzt ist. Die Bremse 20 ist axial zwischen dem Drehgeber-Sensorsystem 22 und dem Motor 10 auf einer B-Seite des Motors 10 angeordnet. Die B-Seite des Motors 10, oder besser gesagt das B-Lagerschild 42, bezeichnet eine "Lüfterseite" der Maschine 16. Ein axial gegenüberliegendes, hier nicht dargestelltes A-Lagerschild bezeichnet typischerweise eine Abtriebsseite. Die Umgebung 12 zeichnet sich also insbesondere dadurch aus, dass eine "B-Seite" der Maschine 16 betrachtet wird, die maschinenherstellerseitig immer äußerst kompakt gebaut wird.

Die Bremse 20 wird elektromagnetisch betätigt, indem eine integrierte Spule 44, die in den Figuren 1C und 1D nicht dargestellt ist, mit Strom beaufschlagt wird. Durch die Strombeaufschlagung erzeugt die Bremse 20 ein Störfeld 14, wie es in den Figuren 1C und 1D durch entsprechende Feldlinienpfeile angedeutet ist. Da die Spule 44 in einer radialen Ebene liegt, verlaufen die Feldlinien des Störfelds 14 im Bereich der Maschinenwelle 30 im Wesentlichen parallel zur Maschinenwelle 30 und zur Wellenachse 34. Wenn die Maschinenwelle 30 aus einem magnetisch leitenden Material gefertigt ist, verstärkt sich die parallele Ausrichtung innerhalb der Welle 30. Die Feldlinien verlassen die Welle 30 auf axialer Höhe der Ebene 36 jedoch im Wesentlichen senkrecht zur Wellenachse 34, wie es nachfolgend noch näher erläutert und gezeigt werden wird. Somit "streut" das Störfeld 14 im axialen Bereich der Ebene 36 im Wesentlichen parallel zur Vorzugsmessrichtung 40 in die Ebene 36 hinein. Das Störfeld 14 überlagert sich im Messbereich des Magnetsensors 24 und des Polrads 26 aufgrund seiner nahezu parallelen Ausrichtung verstärkend - oder abschwächend - mit dem Nutzfeld 38. Dies führt dazu, dass der Magnetsensor 24 kein auswertbares Signal liefert.

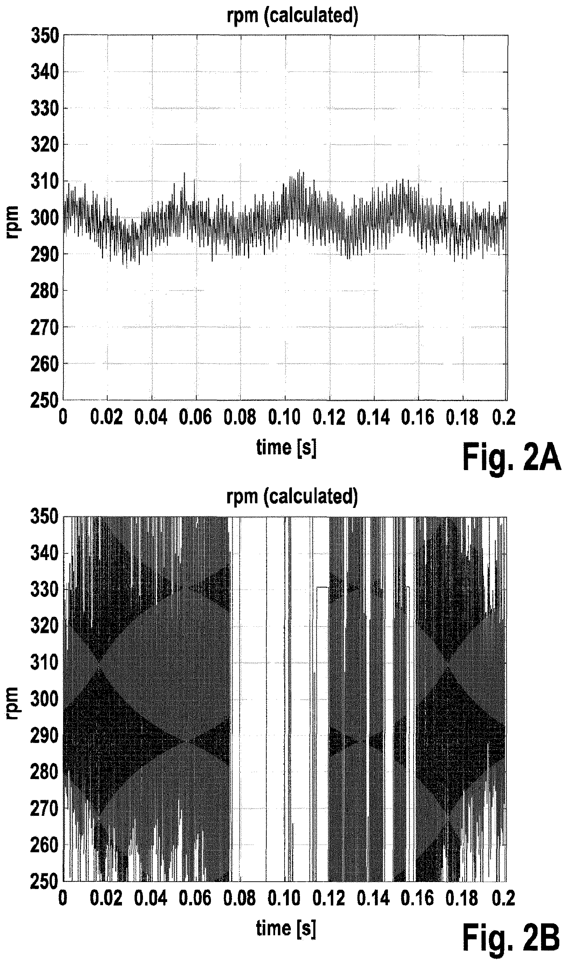

Die Figuren 2A und 2B zeigen berechnete Drehzahlen der Maschinenwelle 30 bei einer Solldrehzahl von 300 Umdrehungen pro Minute und einer Aufnahmedauer von 200 Millisekunden, was in diesem Fall genau einer Umdrehung entspricht. Fig. 2A zeigt die berechnete Drehzahl bei ausgeschalteter Bremse 20. Fig. 2B zeigt die berechnete Drehzahl mit eingeschalteter Bremse 20.

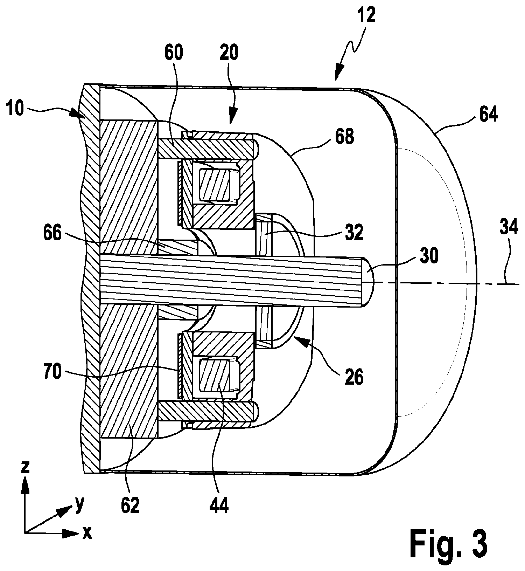

Fig. 3 zeigt eine perspektivische Ansicht einer (Maschinen-)Umgebung 12 mit einem exemplarischen E-Motor 10, einer exemplarischen Federkraftbremse 20, einem Polrad 26 und einem optionalen Polradträger 32, ähnlich der Umgebung 12 der Figuren 1C und 1D. Die Federkraftbremse 20 kann über einen oder mehrere Abstandsbolzen 60 axial beabstandet an einem B-seitigen Maschinenschild 62 maschinenfest befestigt sein. Unter einer maschinenfesten Befestigung versteht man eine Befestigung, bei der das entsprechende Element nicht mit der Maschinenwelle 30 rotiert, sondern feststehend (statisch) mit der Maschine 16 verbunden ist. Ferner ist eine (optionale) Abdeckhaube 64 gezeigt, die das Maschinenschild 62, die Federkraftbremse 20 und das Drehgeber-Sensorsystem 22 umgibt und vorzugsweise dichtend einschließt, wobei vom Drehgeber-Sensorsystem 22 nur das Polrad 26 und der Polradträger 32 gezeigt sind. Auf der Maschinenwelle 30 sitzt ein Zahnrad 66, das als Mitnehmer für eine nicht näher gezeigte und bezeichnete Bremsbacke der Bremse 20 dient. Das Polrad 26 ist drehfest mit der Maschinenwelle 30 über den Polradträger 32 verbunden. In der Fig. 3 ist auch die Spule 44 der Bremse 20 dargestellt. Die Spule 44 ist innerhalb eines Bremsengehäuses 68 ringförmig und koaxial zur Wellenachse 34 angeordnet. Auf einer maschinenschildzugewandten Seite ist das Bremsengehäuse 68, welches vorzugsweise aus einem magnetisch leitenden Material gefertigt ist, durch eine Ankerplatte 70 abgedeckt.

Am Beispiel der Fig. 3 erkennt man leicht, dass ein zur Verfügung stehender Bauraum, der im Wesentlichen durch die Abdeckhaube 64 begrenzt wird, sehr klein ist, um den hier nicht dargestellten Magnetsensor aufzunehmen.

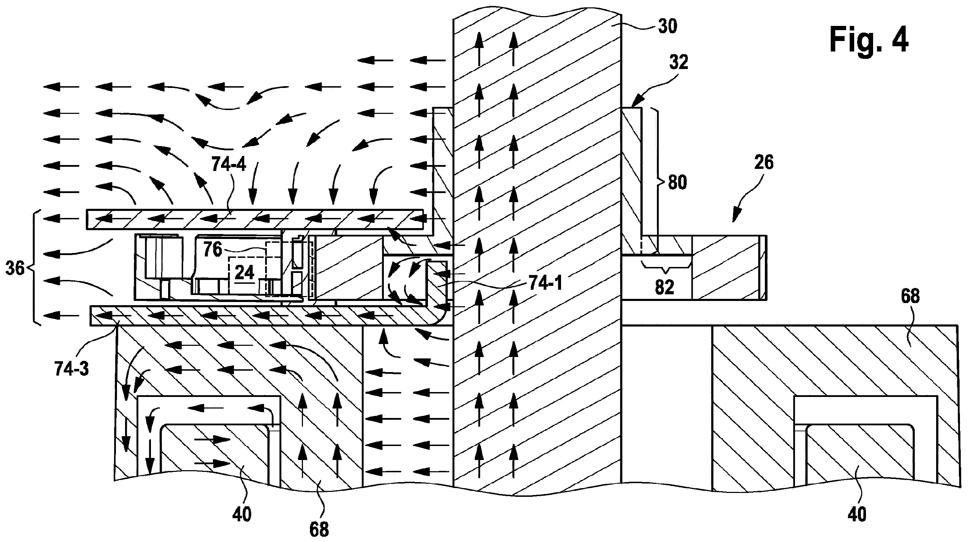

Fig. 4 zeigt eine Schnittansicht, die nahezu identisch zur Fig. 3 ist, wobei der Polradträger 32 leicht abgewandelt ist und wobei zusätzlich ein Abschirmsystem 72 gezeigt ist. Das Abschirmsystem 72 weist
mehrere Ablenkelemente 74 auf. Bei den Ablenkelementen 74 kann es sich um umgeformte Bauteile, Drehteile oder Ähnliches aus einem magnetisch leitenden Material (z.B. Stahl des Typs ST34 mit µᵣ von 6.000-8.000) handeln.

In der Schnittdarstellung der Fig. 4 ist ein erstes Ablenkelement 74-1 gezeigt, das sich im Wesentlichen axial, das heißt parallel zur Maschinenachse 30, erstreckt und das radial zwischen dem Polrad und der Maschinenwelle 30 angeordnet ist. Ferner ist ein drittes Ablenkelement 74-3 und ein viertes Ablenkelement 74-4 zu sehen. Die dritten und vierten Ablenkelemente 74-3 und 74-4 erstrecken sich im Wesentlichen radial nach außen. Das zweite Ablenkelement 74-2, welches sich parallel zum ersten Ablenkelement 74-1 radial weiter außerhalb des Polrads 26 erstreckt, ist in der Schnittdarstellung der Fig. 4 nicht zu sehen. Das dritte Ablenkelement 74-3 verbindet das erste Ablenkelement 74-1 physisch mit dem zweiten Ablenkelement 74-2, wie es nachfolgend noch näher erläutert werden wird. Das dritte und das vierte Ablenkelement 74-3 und 74-4 erstrecken sich parallel zueinander. Das dritte und das vierte Ablenkelement 74-3 und 74-4 erstrecken sich vorzugsweise entlang den axial äußeren Grenzen der Ebene 36 (vgl. Figuren 1A und 1C).

Die Ablenkelemente 74 sind üblicherweise maschinenfest angeordnet. In der Fig. 4 ist das dritte Ablenkelement 74-3 maschinenfest mit dem Bremsengehäuse 78 verbunden.

Der Magnetsensor 24 bzw. dessen Position ist in der Fig. 4 durch eine Strichlinie angedeutet. Der Magnetsensor 24 ist axial zwischen den dritten und vierten Ablenkelementen 74-3 und 74-4 angeordnet. Sowohl der Magnetsensor 24 als auch das Polrad 26 sind innerhalb eines nahezu störfeldfreien Messvolumens 76 angeordnet, das in Fig. 4 ebenfalls durch eine Strichlinie angedeutet ist. Das Messvolumen 76 ist störfeldfrei, weil die magnetisch leitenden Ablenkelemente 74 dafür sorgen, dass das Störfeld 14 nicht in das Messvolumen 76 eindringt. Das Messvolumen 76 spannt sich in dem Raum zwischen dem Magnetsensor 24 und den Permanentmagneten 28 auf, die für die Erzeugung des (auswertbaren) Nutzfelds 38 verantwortlich sind. In seiner kleinsten Ausgestaltung ist das Messvolumen 76 gerade so groß, dass der Raum zwischen dem Magnetsensor 24 und den entsprechenden Permanentmagneten 28 störfeldfrei ist. Dies bedeutet, dass der Magnetsensor 26 und die Permanentmagneten 28 von außen direkt an diesen kleinsten Raum angrenzen. Selbstverständlich kann das Messvolumen 76 auch größer ausgebildet werden, so dass das Messvolumen 76 auch den Magnetsensor 24 und/oder die relevanten Permanentmagneten 28 zumindest teilweise einschließt.

Bei der Ausführungsform gemäß der Fig. 4 reicht das störfeldfreie Messvolumen 76 eigentlich noch weiter radial nach außen, als es gezeigt ist, weil die dritten und vierten Ablenkelemente 74-3 und 74-4 sich radial weit nach außen erstrecken, so dass auch weitere Bestandteile (z.B. Auswerteelektronik, Schnittstellen, etc.) des Magnetsensors 24 räumlich aufgenommen werden können.

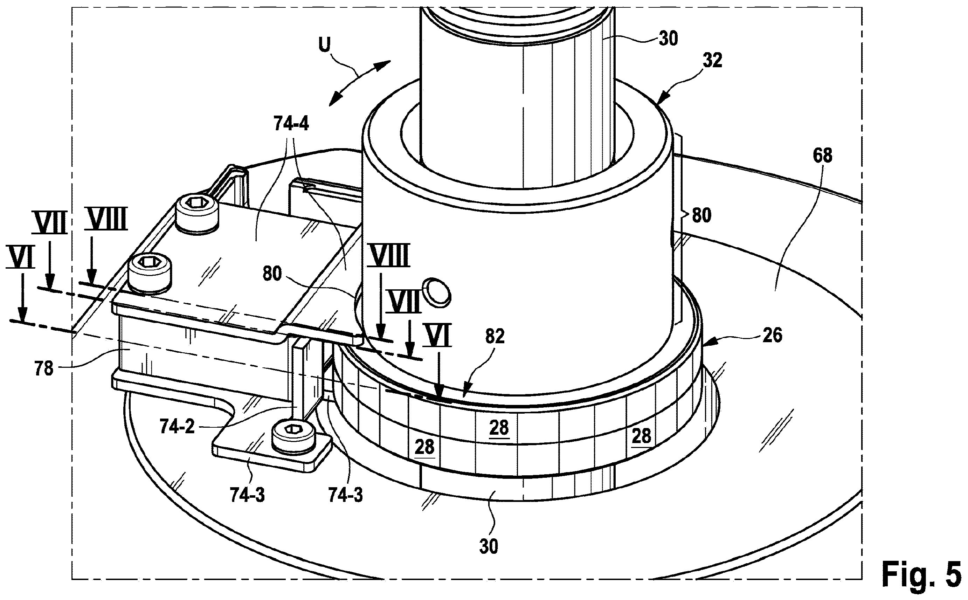

Fig. 5 zeigt eine perspektivische Ansicht der Umgebung 12 der Fig. 4. Das dritte und vierte Ablenkelement 74-3 und 74-4 sind deutlich zu erkennen, die ein Sensorgehäuse 78 Sandwich-artig umgeben. Ferner ist hier ein erstes Teil des zweiten axial orientierten Ablenkelements 74-2 dargestellt. Der Polradträger 32 weist einen axialen Hülsenabschnitt 80 und einen radial vorstehenden Kragenabschnitt 82 auf. Das vierte Ablenkelement 74-4 weist im Bereich des zweiten Ablenkelements 74-2 z.B. eine leichte axiale Stufe auf. Im Bereich des Polträgers 32 ist eine der Maschinenachse 30 zugewandte Kante 84 des vierten Ablenkelements 74-4 formschlüssig (und beabstandet) zum radial benachbarten Polträger 32 ausgebildet. In der Umfangsrichtung U ist eine Länge des vierten Ablenkelements 74-4 so gewählt, dass solche Permanentmagneten 28, die das auswertbare Nutzfeld 38 (vergleiche Fig. 1A) erzeugen, gegenüber dem Störfeld 14 (vergleiche Figuren 1C und 1D) abgeschirmt sind.

Dies ergibt sich insbesondere aus den in Fig. 4 eingezeichneten Pfeilen, die die Magnetfeldlinien verdeutlichen, die durch das Störfeld 14 hervorgerufen werden. Das Störfeld ist nicht vollständig gezeigt. Es sind nur relevante Teile gezeigt. Innerhalb der Welle 30 sind die Feldlinien axial orientiert. Aus der Oberfläche der Maschinenwelle 30 treten die Feldlinien nahezu senkrecht aus. Axial unterhalb des Drehgeber-Sensorsystems 22 treten die Feldlinien senkrecht in das Bremsengehäuse 68 ein, das in der Fig. 4 aus einem magnetisch leitenden Material gefertigt ist. Die Maschinenwelle 30 ist im Beispiel der Figur übrigens ebenfalls aus einem magnetisch leitenden Material gefertigt. Im Axialbereich der Sensorebene 36 treten die Feldlinien radial in das axial orientierte erste Ablenkelement 74-1 ein und werden innerhalb des ersten Ablenkelements 74-1 entlang des ersten Ablenkelements 74-1 in das dritte Ablenkelement 74-3 umgelenkt, um dieses an dessen radialem äußeren Ende wieder zu verlassen. Da der Polradträger 32 aus einem magnetisch nicht leitenden Material gefertigt ist, das eine Permeabilität µᵣ von ungefähr 1 (Luft) aufweist, treten die Magnetfeldlinien nahezu ungestört durch den Polträger 32 hindurch. Axial zwischen dem ersten Ablenkelement 74-1 und dem vierten Ablenkelement 74-4 werden die aus der Maschinenwelle 30 kommenden Magnetfeldlinien in die entsprechenden Ablenkelemente 74-1 und 74-4 umgelenkt. Die Magnetfeldlinien, die in das vierte Ablenkelement 74-4 eintreten, folgen dem vierten Ablenkelement 74-4 bis an dessen äußeren radialen Ende. Dort treten die Feldlinien wieder aus und orientieren sich an dem eigentlichen Verlauf der Magnetfeldlinien des Störfelds 14.

Die Magnetfeldlinien, die durch das Polrad 26 selbst erzeugt werden, d.h. das Nutzfeld 38, sind in der Fig. 4 nicht dargestellt. Aus der Darstellung der Fig. 4 erkennt man aber, dass in einem Innenraum (inkl. dem Messvolumen), der durch die Ablenkelemente 74 gebildet wird, nahezu keine Feldlinien des Störfelds 14 vorhanden sind. Insbesondere im Messvolumen 76 sind ggf. noch vernachlässigbar kleine Feldkomponenten des Störfelds 14 vorhanden. Platziert man den Magnetsensor 24 und das Polrad 26 in diesem Bereich, so ist trotz eines erheblichen Störfelds 14, das bis um den Faktor 300 größer als das Nutzfeld 38 sein kann, ein störungsfreier Betrieb möglich.

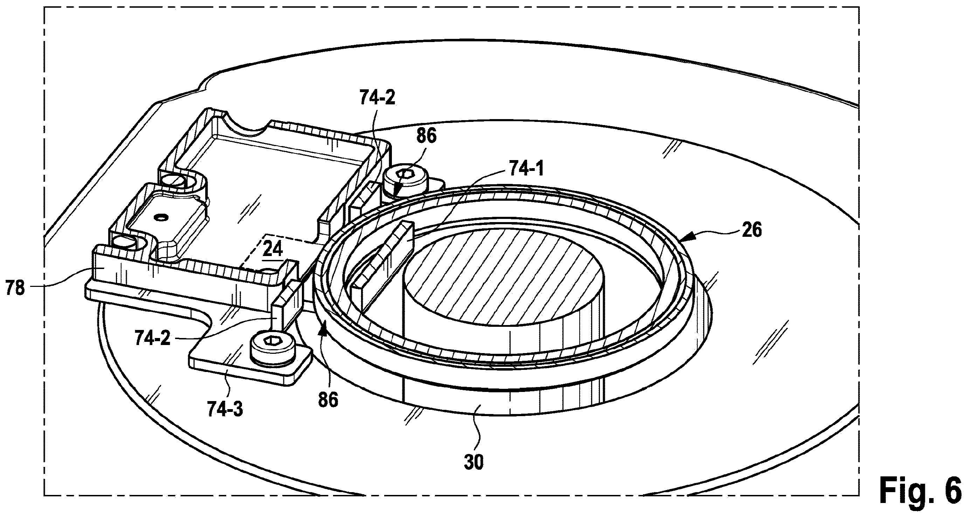

Fig. 6 zeigt das erste Ablenkelement 74-1 der Fig. 4 nochmals deutlicher. Fig. 6 stellt eine Schnittansicht senkrecht zur Maschinenachse 30 entlang einer Linie VI-VI in Fig. 5 dar. Man erkennt, dass das axiale erste Ablenkelement 74-1 radial zwischen dem Polrad 26 und der Maschinenwelle 30 angeordnet ist. Das axiale zweite Ablenkelement 74-2 ist zweiteilig ausgebildet. Das zweite Ablenkelement 74-2 erstreckt sich ebenfalls in axialer Richtung und insbesondere parallel zum ersten Ablenkelement 74-1. Sowohl eine Länge des ersten Ablenkelements 74-1 als auch eine Länge der beiden zweiten Ablenkelemente 74-2 sind so gewählt, dass möglichst viele der Permanentmagneten 28 des Polrads 26 abgeschirmt umgeben werden. Die Länge des ersten Ablenkelements 74-1 ist im Wesentlichen durch den Durchmesser des Polrads 26 begrenzt. Das erste und das zweite Ablenkelement 74-1 und 74-2 sind so dimensioniert und ausgebildet, dass sie einen kanalförmigen Durchgang 86 für das Polrad zwischen sich definieren. Der Durchgang 86 stellt einen Raum dar, durch welchen sich das Polrad 36 im Betrieb bewegt.

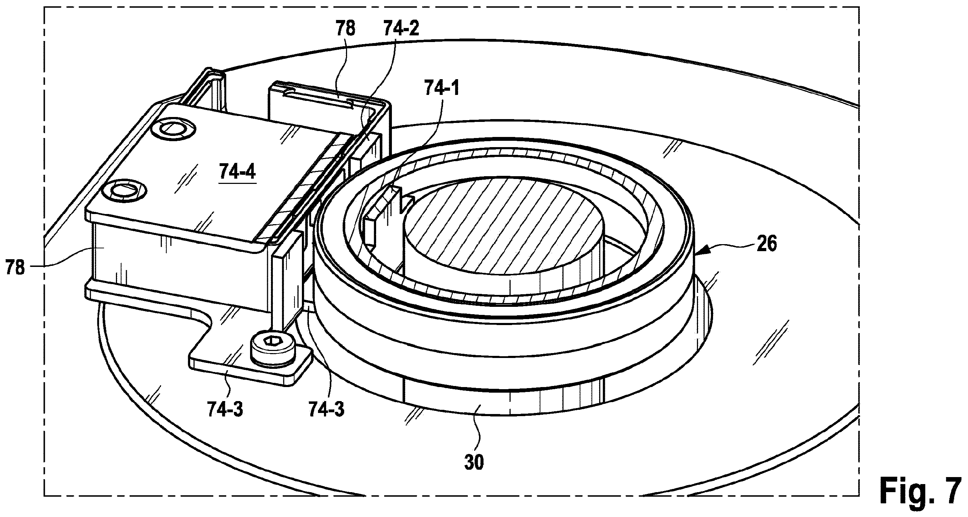

Fig. 7 zeigt eine weitere Schnittansicht ähnlich der Fig. 6, jedoch entlang einer Linie VII-VII in Fig. 5. Der Schnitt VII-VII verläuft knapp oberhalb der Oberseite des vierten Ablenkelements 74-4. Die zweiten Ablenkelemente 74-2 sind nun vollständig dargestellt. Das erste Ablenkelement 74-1 ist in der axialen Richtung nach oben nochmals verjüngt, um sich einer Kontur des Polrads 26 möglichst optimal anzupassen. Die ersten bis dritten Ablenkelemente 74-1 bis 74-3 sind vorzugsweise einstückig (zum Beispiel durch Falzen) ausgebildet.

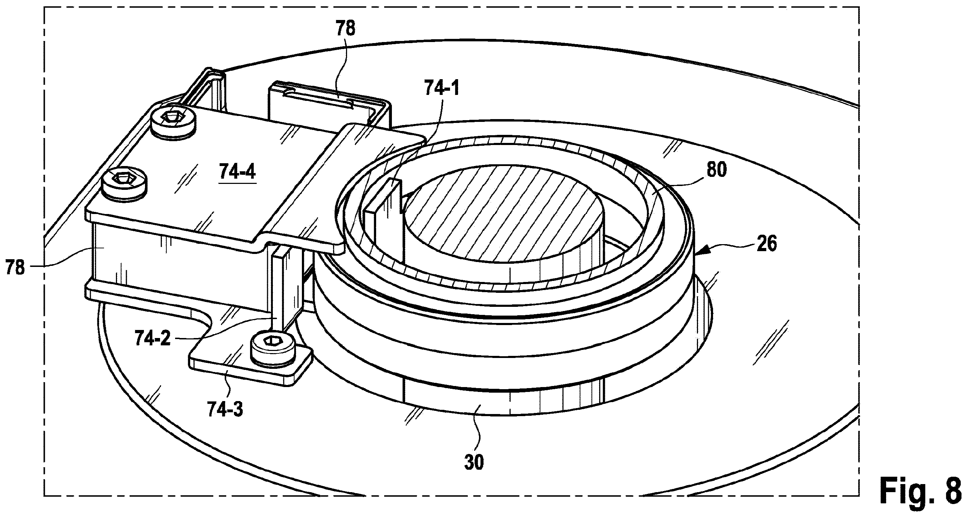

Fig. 8 zeigt eine Schnittansicht entlang einer Linie VIII-VIII in Fig. 5, ähnlich zu den Schnittansichten der Figuren 6 und 7, zwecks Verdeutlichung der formschlüssigen Anpassung des vierten Ablenkelements 74-4 an die Kontur des Hülsenabschnitts 80 des Polradträgers 32.

Es versteht sich, dass das Sensorgehäuse 78 optional einstückig mit den Ablenkelementen 74 ausgebildet sein kann. Ferner versteht es sich, dass das vierte Ablenkelement 74-4 auch physisch mit den zweiten Ablenkelementen 74-2 verbunden sein kann.

Außerdem könnte sich das erste Ablenkelement 74-1 und/oder das dritte Ablenkelement 74-3 vollumfänglich, d.h. 360°, um die Welle 30 erstrecken. In diesem Fall wäre das erste Ablenkelement 74-1 ringförmig und/oder das dritte Ablenkelement 74-3 (kreis-) scheibenförmig ausgebildet.

Zur Verdeutlichung der sehr kleinen Bauräume ist ein Durchmesserbereich für die Bremse 20 von exemplarisch 80 bis 200 mm angegeben.

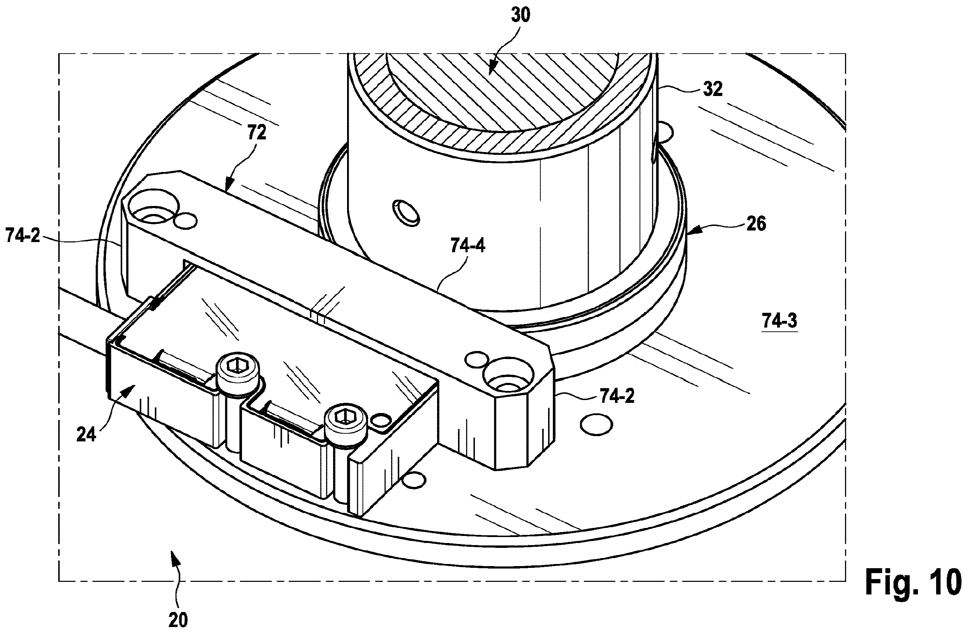

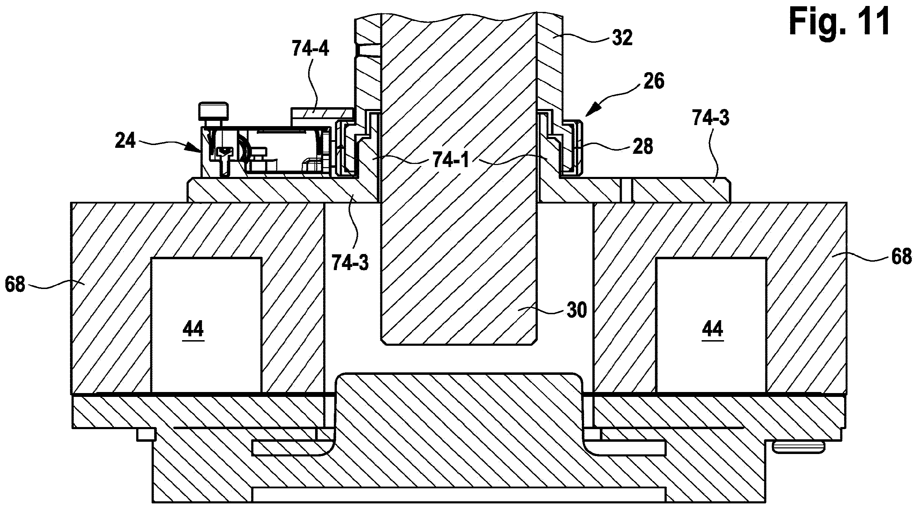

Die Figuren 10 und 11 zeigen eine weitere Ausführungsform des Abschirmsystems 72. Fig. 10 zeigt eine perspektivische Ansicht auf das Abschirmsystem 72. Fig. 11 zeigt eine Schnittansichtentlang der axialen Richtung mittig durch das Abschirmsystem 72 der Fig. 10.

Das Abschirmsystem 72 der Figuren 10 und 11 weist wiederum das axiale erste Ablenkelement 74-1, exemplarisch zwei axiale zweite Ablenkelemente 74-2, das dritte scheibenförmige radiale Ablenkelement 74-3 sowie das plattenförmige radiale vierte Ablenkelement 74-4 auf. Das Abschirmsystem 72 der Figuren 10 und 11 unterscheidet sich von den bisherigen Abschirmsystemen 72 im Wesentlichen dadurch, dass das dritte Ablenkelement 74-3 scheibenförmig (vorzugsweise als Drehteil) ausgebildet ist. Die entsprechende Scheibe erstreckt sich vorzugsweise über 360° und radial annährend so weit die Bremse 20 und der Motor 10. Selbstverständlich können auch andere Gradzahlen als 360° gewählt werden. Das radiale dritte Ablenkelement 74-3 ist vorzugsweise einstückig mit dem axialen ersten Ablenkelement 74-1 ausgebildet. Eine Kontur des ersten Ablenkelements 74-1 ist bevorzugt an eine Kontur des Polradträgers 32 derart angepasst, dass möglichst wenig Luft zwischen dem ersten Ablenkelement 74-1 und dem Polradträger 32 vorhanden ist.

Die zweiten Ablenkelemente 74-2 und das vierte Ablenkelement 74-4 sind bügelförmig ausgebildet und dienen einer Fixierung und Positionierung des Magnetsensors 24 relativ zum Polrad 26 bzw. der Maschinenwelle 30. Dieser Bügel umgibt hier einen radial innen liegenden Teil des Magnetsensors 24. Im Unterschied zu den bisherigen Ausführungsformen des Abschirmsystems 72 sind die beiden zweiten Ablenkelemente 74-2 jedoch nur außen positioniert, wie es in der Fig. 10 gezeigt ist. Dies bedeutet, dass zwischen den beiden in Fig. 10 gezeigten zweiten Ablenkelementen 74-2 keine weiteren zweiten Ablenkelemente 74-2 angeordnet sind. Die beiden in Fig. 10 gezeigten zweiten Ablenkelemente 74-2 stellen die Schenkel des U-förmigen Bügels dar, mit dem der Magnetsensor 24 fixiert und positioniert wird. Das vierte Ablenkelement 74-4 ist plattenförmig ausgebildet und verbindet die beiden zweiten Ablenkelemente 74-2, vorzugsweise einstückig, miteinander. Eine Kontur des vierten Ablenkelements 74-4 ist hier nicht an den Polradträger 32 angepasst. Das vierte Ablenkelement 74-4 stellt also vorzugsweise einen geradlinigen Streifen dar. Dies ist auch ausreichend, weil die wesentlichen Störfeldkomponenten durch das axiale erste Ablenkelement 74-1 geblockt bzw. umgelenkt werden.

Der Polradträger 32 ist bei der Ausführungsform gemäß der Figuren 10 und 11 wiederum magnetisch nicht leitend ausgebildet. Der Polradträger 32 kann zum Beispiel aus Edelstahl des Typs 1.4301 mit einer Permeabilität von µᵣ≤2 gefertigt sein. Alternativ kann der Polradträger 32 zum Beispiel aus Aluminium hergestellt sein. Die Ablenkelemente 74 sind wiederum magnetisch leitend und können zum Beispiel aus ST37 (S235JR) mit einer Permeabilität von ca. 6.000 bis 8.000 gefertigt sein.

Ein großer Vorteil, der in der speziellen Ausführung der Figuren 10 und 11 zu sehen ist, liegt darin, dass insbesondere die ersten und dritten Ablenkelemente 74-1 und 74-3 als ein einziges Drehteil herstellbar sind. Ferner deckt der scheibenförmige Körper des dritten Ablenkelements 74-3 das Gehäuse 68 der Bremse 20 großflächig ab, so dass im Wesentlichen die Maschinenwelle 30 als Störfeldquelle anzusehen ist.

### Bezugszeichenliste:

- 10: Elektromotor/Motor
- 12: Umgebung
- 14: magnetisches Störfeld
- 16: Maschine, vorzugsweise elektrisch
- 18: Zubehör
- 20: (Federkraft-)Bremse
- 22: Drehgeber-Sensorsystems, magnetisch
- 24: Magnetsensor
- 26: Polrad
- 28: Permanentmagnet
- 30: (Maschinen-)Welle
- 32: Polradträger
- 34: Wellenachse
- A: axiale Richtung
- R: radiale Richtung
- 36: (Sensor-)Ebene
- 38: Nutzfeld, magnetisch
- 40: (Vorzugs-)Messrichtung von 24
- 42: (B-)Maschinenschild von 16
- 44: Spule von 20
- 60: Abstandsbolzen
- 62: Maschinenschild
- 64: Abdeckhaube
- 66: Zahnrad
- 68: Bremsengehäuse
- 70: Ankerplatte
- 72: Abschirmsystem
- 74: Ablenkelement
- 76: Messvolumen, störfeldfrei
- 78: Gehäuse von 24
- 80: Hülsenabschnitt von 32, axial
- 82: Kragenabschnitt von 32, radial vorstehend
- 84: Kante von 74-4
- 86: Durchgang

## Patentansprüche

1. Magnetisches Drehgeber-Sensorsystem (22) mit einem Abschirmsystem (72) für das magnetisches Drehgeber-Sensorsystem (22) in einer Umgebung (12) einer elektrischen Maschine (16) mit einem magnetischen Störfeld (14),
wobei das Störfeld (14) von einem elektromagnetisch betriebenen Zubehör (18), das eine Federkraftbremse ist, und von der elektrischen Maschine (16) hervorgerufen wird,
wobei das Drehgeber-Sensorsystem (22) einen Magnetsensor (24), ein Polrad (26) und einen Polradträger (32) aufweist, wobei das Zubehör maschinenfest und axial benachbart zum Drehgeber-Sensorsystems (22) an einem Maschinenschild (62) gemeinsam mit dem Magnetsensor (24) befestigbar ist,
wobei das Polrad (26) in Umfangsrichtung (U) eine Vielzahl von nutzfelderzeugenden Permantmagneten (28) wechselnder magnetischer Polarität aufweist,
wobei der Polradträger (32) eingerichtet ist, drehfest auf einer sich axial erstreckenden, rotierenden Maschinenwelle (30), die aus einem magnetisch leitenden Material gefertigt ist und deren Drehzahl und/oder Winkelposition mittels des Drehgeber-Sensorsystems (22) zu bestimmen ist, montiert zu werden,
wobei der Magnetsensor (24) in einem montierten Zustand des Drehgeber-Sensorsystems (22) zur Maschinenwelle (30) in einer störfeldbeeinflussbaren Rotationsebene (36) des Polrads (26) und direkt gegenüberliegend zu dem Polrad (26) positioniert ist,
wobei das Abschirmsystem (72) mindestens ein magnetisch leitendes maschinenfestes Ablenkelement (74) aufweist,
welches so geformt und dimensioniert ist, dass sich im montierten Zustand ein im Wesentlichen störfeldfreies Messvolumen (76) einstellt, an welches der Magnetsensor (24) und solche der Permanentmagneten (28) zumindest angrenzen, die zum Erzeugen eines auswertbaren Nutzfelds (38) erforderlich sind, wenn das Störfeld (14) aktiv ist,
**dadurch gekennzeichnet, dass** ein erstes Ablenkelement (74-1) vorgesehen ist, das sich längs parallel zur Maschinenwelle (30) erstreckt,
wobei das erste Ablenkelement (74-1) radial zwischen der Maschinenwelle (30) und dem Polrad (26) angeordnet ist,
wobei das mindestens eine Ablenkelement (74) so angeordnet ist, dass das mindestens eine Ablenkelement das Messvolumen (76) derart umgibt, dass Komponenten des Störfelds (14), die annähernd parallel zu einer Messrichtung (40) des Magnetsensors (24) orientiert sind, durch das mindestens eine Ablenkelement (74) um das Messvolumen (76) herum geführt werden und dass ein Durchgang (86) für das rotierende Polrad (26) und den Polradträger (32) verbleibt.
wobei ferner ein zweites Ablenkelement (74-2) vorgesehen ist, das sich längs parallel zur Maschinenwelle (30) erstreckt, wobei das zweite Ablenkelement (74-2) radial außerhalb des Polrads (26) angeordnet ist,
wobei ferner ein drittes Ablenkelement (74-3) vorgesehen ist, welches sich im Wesentlichen entlang der Rotationsebene (36) erstreckt und welches das erste und das zweite Ablenkelement (74-1, 74-2) verbindet.

2. System nach Anspruch 1, wobei das Abschirmsystem ferner das Polrad (26) und den Polradträger (32) aufweist, der einen axialen Hülsenabschnitt (80) mit einem radial vorstehenden Kragenabschnitt (28) aufweist, an welchem die Permanentmagneten (28) radial befestigt sind, wobei der Polradträger (32) zumindest in einem Maschinenwellen-Nahbereich aus einem magnetisch nicht leitenden Material gefertigt ist und wobei das erste Ablenkelement (74-1) zwischen dem Polrad (26), der Maschinenwelle (30) und dem Kragenabschnitt (82) positioniert ist.

3. System nach einem der Ansprüche 1 oder 2, wobei ferner ein viertes Ablenkelement (74-4) vorgesehen ist, dass sich parallel, axial beabstandet und radial gegenüberliegend zum dritten Ablenkelement (74-3) erstreckt, wobei die dritten und vierten Ablenkelemente (74-3, 74-4) vorzugsweise mindestens so groß wie eine Grundfläche des Magnetsensors (24) dimensioniert sind und wobei das vierte Ablenkelement (74-4) vorzugsweise mit dem zweiten Ablenkelement (72-2) verbunden ist.

4. System nach einem der vorhergehenden Ansprüche, wobei das mindestens eine Ablenkelement (74) ein Gehäuse (78) des Magnetsensors (24) bildet, das den Magnetsensor (74) aufnimmt und das ferner den oder die nutzfelderzeugenden Permanentmagneten (28) zumindest teilweise umgibt.

5. System nach einem der Ansprüche 1 bis 4, wobei die Maschine (16) insbesondere ein Elektromotor (10) ist, wobei das elektromagnetisch betriebene Zubehör (18) gemeinsam mit dem Magnetsensor (24) innerhalb einer Maschinenabdeckhaube (68) befestigbar ist.

6. System nach einem der Ansprüche 1 bis 5, wobei der Magnetsensor (24) mindestens ein Hall-Sensor und/oder ein xMR-Sensor ist.

7. System nach einem der Ansprüche 1 bis 6, wobei sich das mindestens eine Ablenkelement (74) in der Umfangsrichtung (U) mindestens entlang den Permanentmagneten (28) erstreckt, die zum Erzeugen des durch den Magnetsensor (24) auswertbaren Nutzfelds (38) erforderlich sind.

## Claims

1. A magnetic rotary-encoder sensor system (22) comprising a screening system (72) for the magnetic rotary-encoder sensor system (22) in an environment (12), which includes a magnetic noise field (14), of an electric machine (16),
wherein the noise field (14) is caused by an electromagnetically operated accessory (18), which is a spring-force brake, and by the electric machine (16),
wherein the rotary-encoder sensor system (22) comprises a magnetic sensor (24), a pole wheel (26), and a pole-wheel carrier (32), the accessory (18) being fixable, in a machine-fixed manner and axially adjacent to the rotary-encoder sensor system (22), to a machine shield (62) together with the magnetic sensor (24),
wherein the pole wheel (26) comprises, in a circumferential direction (U), a plurality of permanent magnets (28) of alternating magnetic polarity generating a useful field,
wherein the pole-wheel carrier (32) is configured to be mounted in a rotationally-fixed manner to a rotating machine shaft (30) extending axially and being manufactured of a magnetically conducting material, a rotational speed and/or an angular position of which rotating machine shaft (30) is to be determined by means of the rotary-encoder sensor system (22),
wherein the magnetic sensor (24) is positioned, in a mounted state of the rotary-encoder sensor system (22), relative to the machine shaft (30) in a rotational plane (36) of the pole wheel (26), which can affect the noise field, and directly opposite to the pole wheel (26),
wherein the screening system (72) comprises at least one magnetically conducting machine-fixed deflection element (74),
the deflection element (74) being formed and dimensioned such that, in the mounted state, a measuring volume (76), which is substantially free of the noise field, is established, to which the magnetic sensor (24) and such ones of the permanent magnets (28) are at least adjacent which are required for generating an evaluable useful field (38), when the noise field (14) is active,
**characterized in that** a first deflection element (74-1), which is longitudinally extending parallel to the machine shaft (30), is provided,
wherein the first deflection element (74-1) is arranged radially between the machine shaft (30) and the pole wheel (26),
wherein the at least one deflection element (74) is arranged such that the at least one deflection element surrounds the measuring volume (76) so that components of the noise field (14) being arranged almost parallel to a measuring direction (40) of the magnetic sensor (24) are guided by the at least one deflection element (74) around the measuring volume (76), and so that a passage (86) remains for the rotating pole wheel (26) and the pole-wheel carrier (32),
wherein further a second deflection element (74-2) is provided, which extends longitudinally parallel to the machine shaft (30), wherein the second deflection element (74-2) is arranged radially external to the pole wheel (26),
wherein further a third deflection element (74-3) is provided, which extends substantially along the rotational plane (36) and which connects the first and second deflection elements (74-1, 74-2).

2. The system of claim 1 further comprising the pole wheel (26) and the pole-wheel carrier (32), which comprises an axial sleeve portion (80) including a radial protruding collar portion (28), to which the permanent magnets (28) are fixed radially, wherein the pole-wheel carrier (32) is manufactured, at least in a region close to the machine-shaft, of a material which is magnetically non-conducting, and wherein the first deflection element (74-1) is positioned between the pole wheel (26), the machine shaft (30), and the collar portion (82).

3. The system of any of claims 1 or 2, wherein further a fourth deflection element (74-4) is provided extending parallel, axially distanced, and radially opposite to the third deflection element (74-3), wherein the third and fourth deflection elements (74-3, 74-4) are preferably dimensioned at least as large as a base area of the magnetic sensor (24), and wherein the fourth deflection element (74-4) is preferably connected to the second deflection element (72-2).

4. The system of any of the preceding claims, wherein the at least one deflection element (74) forms a casing (78) of the magnetic sensor (24) receiving the magnetic sensor (74) and further surrounding, at least partially, the permanent magnets (28) generating the useful field.

5. The system of any of claims 1 to 4, wherein the machine (16) in particular is an electric motor (10), wherein the electromagnetically operated accessory (18) is fixable, together with the magnetic sensor (24), within a machine-guard cover (68).

6. The system of any of claims 1 to 5, wherein the magnetic sensor (24) is at least one of a Hall sensor or an xMR sensor.

7. The system of any of claims 1 to 6, wherein the at least one deflection element (74) extends in the circumferential direction (U) at least along the permanent magnets (28) required for generating the useful field (38) which is evaluable by the magnetic sensor (24).

## Revendications

1. Système à capteur pour codeur rotatif (22) magnétique comportant un système de blindage (72) pour le système à capteur pour codeur rotatif (22) magnétique dans un environnement (12) d'une machine électrique (16) comportant un champ parasite (14) magnétique,
dans lequel le champ parasite (14) est provoqué par un accessoire à fonctionnement électromagnétique (18), qui est un frein à ressort, et par la machine électrique (16),
dans lequel le système à capteur pour codeur rotatif (22) présente un capteur magnétique (24), une roue polaire (26) et un support pour roue polaire (32), dans lequel l'accessoire peut être fixé de manière solidaire à la machine et de manière à être axialement adjacent au système à capteur pour codeur rotatif (22) sur une plaque de machine (62), conjointement avec le capteur magnétique (24),
dans lequel la roue polaire (26) présente, dans la direction circonférentielle (U), une pluralité d'aimants permanents (28) générant un champ utile et de polarité magnétique alternante,
dans lequel le support pour roue polaire (32) est conçu pour être monté de manière solidaire en rotation sur un arbre de machine (30) rotatif s'étendant axialement qui est fabriqué à partir d'un matériau magnétiquement conducteur et dont la vitesse de rotation et/ou la position angulaire doivent être déterminées au moyen du système à capteur pour codeur rotatif (22),
dans lequel le capteur magnétique (24) est positionné, dans un état monté du système à capteur pour codeur rotatif (22), par rapport à l'arbre de machine (30) dans un plan de rotation (36) de la roue polaire (26) pouvant être influencé par un champ parasite et directement en face de la roue polaire (26),
dans lequel le système de blindage (72) présente au moins un élément de déviation (74) magnétiquement conducteur et solidaire à la machine,
lequel est formé et dimensionné de sorte qu'à l'état monté, un volume de mesure (76) sensiblement exempt de champ parasite est établi, auquel le capteur magnétique (24) et les aimants permanents (28), lesquels sont nécessaires pour générer un champ utile (38) exploitable lorsque le champ parasite (14) est actif, sont au moins adjacents,
**caractérisé en ce qu'**un premier élément de déviation (74-1) est prévu, lequel s'étend longitudinalement parallèlement à l'arbre de machine (30),
dans lequel le premier élément de déviation (74-1) est disposé radialement entre l'arbre de machine (30) et la roue polaire (26),
dans lequel l'au moins un élément de déviation (74) est disposé de sorte que l'au moins un élément de déviation entoure le volume de mesure (76) de telle sorte que des composants du champ parasite (14), lesquels sont orientés approximativement parallèlement à une direction de mesure (40) du capteur magnétique (24), sont guidés par l'au moins un élément de déviation (74) autour du volume de mesure (76) et qu'il reste un passage (86) pour la roue polaire (26) rotative et le support pour roue polaire (32),
dans lequel un deuxième élément de déviation (74-2) est en outre prévu, lequel s'étend longitudinalement parallèlement à l'arbre de machine (30), dans lequel le deuxième élément de déviation (74-2) est disposé radialement à l'extérieur de la roue polaire (26),
dans lequel un troisième élément de déviation (74-3) est en outre prévu, lequel s'étend sensiblement le long du plan de rotation (36) et relie le premier et le deuxième élément de déviation (74-1, 74-2).

2. Système selon la revendication 1, dans lequel le système de blindage présente en outre la roue polaire (26) et le support pour roue polaire (32), lequel présente une section formant douille axiale (80) comportant une section formant collerette (28) faisant saillie radialement à laquelle les aimants permanents (28) sont fixés radialement, dans lequel le support pour roue polaire (32) est fabriqué à partir d'un matériau magnétiquement non conducteur au moins dans une zone proche de l'arbre de machine, et dans lequel le premier élément de déviation (74-1) est positionné entre la roue polaire (26), l'arbre de machine (30) et la section formant collerette (82).

3. Système selon l'une des revendications 1 ou 2, dans lequel un quatrième élément de déviation (74-4) est en outre prévu, lequel s'étend parallèlement au troisième élément de déviation (74-3), à distance axiale et radialement en face de celui-ci, dans lequel le troisième et le quatrième élément de déviation (74-3, 74-4) sont de préférence dimensionnés au moins d'une manière aussi grande qu'une surface de base du capteur magnétique (24) et dans lequel le quatrième élément de déviation (74-4) est de préférence relié au deuxième élément de déviation (72-2).

4. Système selon l'une des revendications précédentes, dans lequel l'au moins un élément de déviation (74) forme un boîtier (78) du capteur magnétique (24), lequel boîtier reçoit le capteur magnétique (74) et entoure en outre au moins partiellement le ou les aimants permanents (28) générant un champ utile.

5. Système selon l'une des revendications 1 à 4, dans lequel la machine (16) est en particulier un moteur électrique (10), dans lequel l'accessoire à fonctionnement électromagnétique (18) peut être fixé à l'intérieur d'un capot de machine (68), conjointement avec le capteur magnétique (24).

6. Système selon l'une des revendications 1 à 5, dans lequel le capteur magnétique (24) est au moins un capteur à effet Hall et/ou un capteur xMR.

7. Système selon l'une des revendications 1 à 6, dans lequel l'au moins un élément de déviation (74) s'étend dans la direction circonférentielle (U) au moins le long des aimants permanents (28) nécessaires pour générer le champ utile (38) exploitable par le capteur magnétique (24).
